# FASCICULE DE BREVET EUROPEEN

(11) **EP 4 396 009 B1**
(45) Date de publication et mention de la délivrance du brevet: **27.08.2025**
(21) Numéro de dépôt: 22757304.5
(22) Date de dépôt: 29.07.2022
(51) Int. Cl.: B60H 1/00, B60H 1/32, B60K 1/00, B60K 1/04, B60K 11/02, B60K 11/04

(54) **DISPOSITIF DE GESTION THERMIQUE POUR PLATEFORME MODULAIRE D'UN CHÂSSIS DE VÉHICULE AUTOMOBILE ÉLECTRIQUE**
WÄRMEMANAGEMENTVORRICHTUNG FÜR EINE MODULARE PLATTFORM EINES ELEKTROFAHRZEUGCHASSIS
THERMAL MANAGEMENT DEVICE FOR A MODULAR PLATFORM OF AN ELECTRIC MOTOR VEHICLE CHASSIS

(30) Priorité: 03.09.2021 FR 2109228
(43) Date de publication de la demande: 10.07.2024
(73) Titulaire: VALEO SYSTEMES THERMIQUES, 78320 Le Mesnil Saint-Denis (FR)
(72) Inventeur: NACER BEY, Moussa, 78320 Le Mesnil-Saint-Denis (FR); GARNIER, Sebastien, 78320 Le Mesnil-Saint-Denis (FR); AZZOUZ, Kamel, 78320 Le Mesnil-Saint-Denis (FR); MAMMERI, Amrid, 78320 Le Mesnil-Saint-Denis (FR)
(74) Mandataire: Valeo Powertrain Systems
(86) Numéro de dépôt international: PCT/EP2022/071423
(87) Numéro de publication internationale: WO 2023/030793

(56) Documents cités:
- WO-A1-2015/129141
- CN-A- 113 276 628
- US-A1- 2020 353 795
- US-B2- 10 589 598
- US-B2- 10 766 340

## Description

La présente invention concerne le domaine des dispositifs de gestion thermique pour véhicule électrique et plus particulièrement les dispositifs de gestion thermique pour une plateforme modulaire d'un châssis de véhicule automobile électrique.

Dans le domaine automobile et notamment dans le domaine des véhicules automobiles électriques, pour des raisons de standardisation et d'économie d'échelle, on peut parfois avoir recours à des plateformes modulaires de châssis d'un véhicule automobile électrique. De telles plateformes modulaires comporte notamment les batteries, le train de puissance électrique ainsi que la partie cycle, notamment les roues, le système de freinage et de suspension du véhicule automobile. Par train de puissance électrique du véhicule automobile, on entend plus précisément l'électrique de puissance ainsi que le ou les moteurs électriques du véhicule automobile. Une telle plateforme modulaire est utilisée afin d'avoir une plateforme unique, regroupant la plupart des composants de propulsion, d'alimentation et de stockage électrique sur laquelle il est installé des habitacles et des carrosseries divers, correspondant à différents modèles de véhicules automobiles.

Cependant, afin d'améliorer l'autonomie du véhicule électrique, une grande partie de la place au sein de cette plateforme modulaire est réservée aux batteries. Il reste alors peu d'espace pour intégrer un dispositif de gestion thermique permettant la gestion thermique à la fois des batteries et de l'habitacle. Les dispositifs de gestion thermique conventionnels, comme celui connu du document US 2020/353795 A1, sont généralement encombrants et nécessitent une place importe pour être intégrés dans un véhicule automobile. Ces dispositifs de gestion thermique ne sont dans pas bien adaptés à une intégration au sein d'une telle plateforme modulaire.

Un des buts de la présente invention est donc de remédier au moins partiellement aux inconvénients de l'art antérieur et de proposer un dispositif de gestion thermique amélioré pouvant s'intégrer au sein d'une telle plateforme modulaire.

La présente invention , telle que définie dans la revendication 1, concerne donc un dispositif de gestion thermique pour plateforme modulaire d'un châssis de véhicule automobile électrique, ladite plateforme modulaire comportant les batteries ainsi que le train de puissance électrique du véhicule automobile électrique, le dispositif de gestion thermique comportant :
- un premier module comprenant un premier circuit de fluide caloporteur au sein duquel est destiné un premier fluide caloporteur, ledit premier circuit de fluide caloporteur comportant un compresseur, un premier dispositif de détente et un échangeur de chaleur multi-fluide et un premier échangeur de chaleur,
- un module de refroidissement étant destiné à être traversé par un flux d'air externe, ledit module de refroidissement comportant au moins un premier échangeur de chaleur destiné à être traversé par le flux d'air externe, le module de refroidissement comportant un côté supérieur, un côté inférieur, un premier et un deuxième côtés latéraux opposés l'un à l'autre, lesdits côtés formant une paroi externe du module de refroidissement, ledit module de refroidissement étant destiné à être intégré au sein de la plateforme modulaire,
- un deuxième module comportant une première pompe et une deuxième pompe d'un deuxième circuit de fluide caloporteur au sein duquel est destiné un deuxième fluide caloporteur, ledit deuxième module comportant en outre des moyens de redirection du deuxième fluide caloporteur au sein dudit deuxième circuit de fluide caloporteur,

au moins une partie des composants du premier module sont disposés sur la paroi externe du module de refroidissement, et
caractérisé en ce qu'au moins une partie des composants du deuxième module sont disposés sur la paroi externe du module de refroidissement.

Avantageusement, les composants du premier module sont regroupés sur le côté supérieur du module de refroidissement.

Avantageusement, les composants du deuxième module sont disposés sur un même côté latéral du module de refroidissement.

Avantageusement, les composants du deuxième module sont répartis entre les deux côtés latéraux du module de refroidissement.

Avantageusement, le compresseur et le premier échangeur de chaleur du premier module sont regroupés sur un même côté latéral du module de refroidissement.

Avantageusement, le premier dispositif de détente et l'échangeur de chaleur multi-fluide du premier module sont disposé sur le même coté latéral que le compresseur et le premier échangeur de chaleur.

Avantageusement, le premier dispositif de détente et l'échangeur de chaleur multi-fluide sont disposé sur un côté latéral opposé au côté latéral comportant le compresseur et le premier échangeur de chaleur.

Avantageusement, les composants du deuxième module sont disposés sur le côté supérieur du module de refroidissement.

Avantageusement, les composants du deuxième module sont disposés sur un côté latéral du module de refroidissement opposé au côté latéral comportant les composants du premier module.

Avantageusement, le premier dispositif de détente et l'échangeur de chaleur multi-fluide sont disposé dans le prolongement dudit module de refroidissement, en regard d'un côté dudit module de refroidissement opposé au premier échangeur de chaleur.

Avantageusement, les composants du deuxième module sont répartis entre :
- le côté latéral du module de refroidissement opposé au côté latéral comportant le compresseur et le premier échangeur de chaleur, et/ou
- dans le prolongement dudit module de refroidissement, en regard d'un côté dudit module de refroidissement opposé au premier échangeur de chaleur.

La présente invention , telle que définie dans la revendication 12, concerne également une plateforme modulaire d'un châssis de véhicule automobile électrique, ladite plateforme modulaire comportant les batteries ainsi que le train de puissance électrique du véhicule automobile électrique, ladite plateforme modulaire comportant un dispositif de gestion thermique tel que décrit précédemment.

D'autres caractéristiques et avantages de la présente invention apparaîtront plus clairement à la lecture de la description suivante, fournie à titre illustratif et non limitatif, et des dessins annexés dans lesquels :
[Fig 1] La figure 1 est une représentation schématique en semi-transparence d'une plateforme modulaire selon un premier mode de réalisation,
[Fig 2] la figure 2 est une représentation schématique en perspective d'un module de refroidissement,
[Fig 3] la figure 3 est une représentation schématique en perspective d'un dispositif de chauffage, ventilation et d'air conditionné,
[Fig 4] la figure 4 est une représentation schématique d'un dispositif de gestion thermique selon un premier exemple,
[Fig 5] la figure 5 est une représentation schématique d'un dispositif de gestion thermique selon un deuxième exemple,
[Fig 6] La figure 6 est une représentation schématique d'un dispositif de gestion thermique selon un troisième exemple,
[Fig 7] la figure 7 est une représentation schématique en perspective d'un module de refroidissement et de la répartition de composants selon une première variante d'un premier mode de réalisation,
[Fig 8] la figure 8 est une représentation schématique en perspective d'un module de refroidissement et de la répartition de composants selon une deuxième variante du premier mode de réalisation,
[Fig 9] la figure 9 est une représentation schématique en perspective d'un module de refroidissement et de la répartition de composants selon une première variante d'un deuxième mode de réalisation,
[Fig 10] la figure 10 est une représentation schématique en perspective d'un module de refroidissement et de la répartition de composants selon une alternative de la première variante du deuxième mode de réalisation,
[Fig 11] la figure 11 est une représentation schématique en perspective d'un module de refroidissement et de la répartition de composants selon une deuxième variante du deuxième mode de réalisation,
[Fig 12] la figure 12 est une représentation schématique en vue de dessus d'un module de refroidissement et de la répartition de composants selon une troisième variante du deuxième mode de réalisation.

Sur les différentes figures, les éléments identiques portent les mêmes numéros de référence.

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées et/ou interchangées pour fournir d'autres réalisations.

Dans la présente description, on peut indexer certains éléments ou paramètres, comme par exemple premier élément ou deuxième élément ainsi que premier paramètre et second paramètre ou encore premier critère et deuxième critère, etc. Dans ce cas, il s'agit d'un simple indexage pour différencier et dénommer des éléments ou paramètres ou critères proches, mais non identiques. Cette indexation n'implique pas une priorité d'un élément, paramètre ou critère par rapport à un autre et on peut aisément interchanger de telles dénominations sans sortir du cadre de la présente description. Cette indexation n'implique pas non plus un ordre dans le temps par exemple pour apprécier tel ou tel critère.

Dans la présente description, on entend par « placé en amont » qu'un élément est placé avant un autre par rapport au sens de circulation d'un fluide. A contrario, on entend par « placé en aval » qu'un élément est placé après un autre par rapport au sens de circulation du fluide.

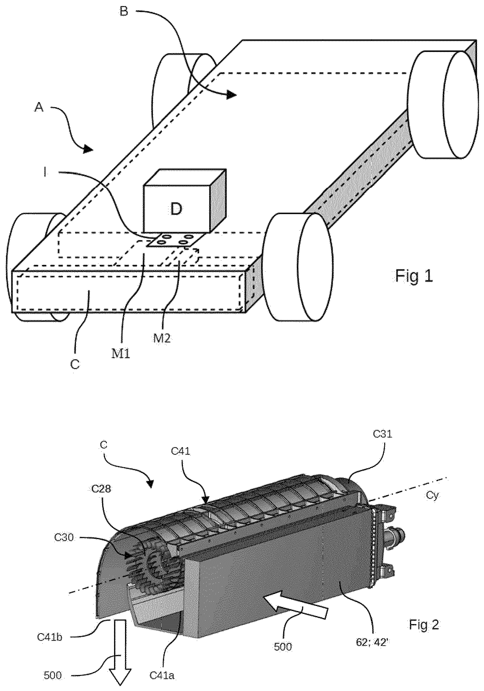

La figure 1 montre une plateforme modulaire A de châssis d'un véhicule automobile électrique. Cette plateforme modulaire A comporte notamment les batteries B, le train de puissance électrique ainsi que la partie cycle du véhicule automobile, par exemple les roues, le système de freinage et de suspension. Par train de puissance électrique du véhicule automobile, on entend plus précisément l'électrique de puissance ainsi que le ou les moteurs électriques du véhicule automobile. Une telle plateforme modulaire A est notamment utilisée afin d'avoir une plateforme sur laquelle peut être installé des habitacles et des carrosseries divers.

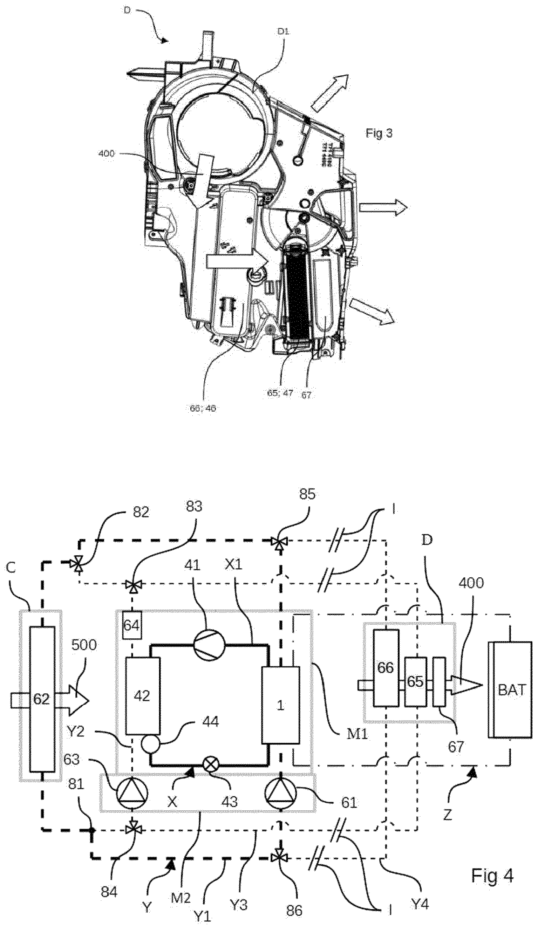

Afin de permettre la gestion thermique des batteries B ainsi que celle de l'habitacle, la plateforme modulaire A comporte un dispositif de gestion thermique comportant au moins deux circuits de fluides caloporteurs X, Y (visibles sur les figures 4, 5 et 7). Le dispositif de gestion thermique comporte plus particulièrement différents modules connectés fluidiquement les uns aux autres afin de former les différents circuits de fluides caloporteurs X, Y.

Le dispositif de gestion thermique comporte ainsi un premier module M1 ainsi qu'un deuxième module M2 qui seront décrit plus en détails plus loin dans la présente description.

Le dispositif de gestion thermique comporte également un module de refroidissement C étant destiné à être traversé par un flux d'air externe 500. Le module de refroidissement C comporte au moins un échangeur de chaleur 62, 42' également destiné à être traversé par le flux d'air externe 500. Ce module de refroidissement C est destiné à être intégré au sein de la plateforme modulaire A, de préférence dans la partie avant de la plateforme modulaire.

Un exemple d'un tel module de refroidissement C est notamment illustré à la figure 2. Le module de refroidissement C peut ainsi comporter un échangeur de chaleur 62, 42' et un premier boîtier collecteur C41 accolé audit échangeur de chaleur 62, 42'. Le premier boîtier collecteur C41 forme de préférence une volute avec une première extrémité ouverte C41a disposée en regard de l'échangeur de chaleur 62, 42' (voir figure 2) et une deuxième extrémité ouverte C41b à l'extrémité opposée de la volute.

Le module de refroidissement C peut comprendre également au moins un ventilateur tangentiel, aussi nommé turbomachine tangentielle C30, configuré de sorte à générer le flux d'air externe 500, par exemple lors de l'arrêt du véhicule automobile ou lorsqu'il est à une vitesse faible. La turbomachine tangentielle C30 comprend un rotor ou turbine (ou hélice tangentielle) C28. La turbine C28 a une forme sensiblement cylindrique. La turbine C28 comporte avantageusement plusieurs étages de pales (ou aubes). La turbine C28 est montée rotative autour d'un axe de rotation Cy, par exemple parallèle au plan formé par l'échangeur de chaleur 62, 42' et s'étendant dans sa largeur. La turbine C28 est plus particulièrement disposée au sein de la volute formée par le premier boitier collecteur. La turbomachine tangentielle C30 est ainsi compacte. L'utilisation d'une telle turbomachine tangentielle C30 permet notamment que le flux d'air externe 500 soit égal sur toute la largeur de l'au moins un échangeur de chaleur 62, 42'. De plus, une telle turbomachine tangentielle C30 permet un gain de place par rapport à des ventilateurs classiques.

La turbomachine tangentielle C30 peut également comporter un moteur C31 configuré pour mettre en rotation la turbine. Le moteur C31 est par exemple adapté à entraîner la turbine en rotation, à une vitesse comprise entre 200 tour/min et 14 000 tour/min. De telles vitesses de rotation permettent notamment de limiter le bruit généré par la turbomachine tangentielle C30.

Dans l'exemple illustré à la figure 2, la turbomachine tangentielle C30 est configurée pour fonctionner en aspiration, c'est-à-dire qu'elle aspire l'air ambiant pour qu'il traverse l'échangeur de chaleur 62, 42 et soit évacué par la deuxième extrémité ouverte C41b de la volute. Alternativement, la turbomachine tangentielle C30 peut fonctionner par refoulement, c'est à dire soufflant l'air depuis la deuxième extrémité ouverte C41b de la volute vers l'échangeur de chaleur 62, 42'.

Le module de refroidissement C peut également comporter un deuxième boîtier collecteur (non représenté) accolé à l'échangeur de chaleur 62, 42' sur sa face opposée à celle comportant le premier boitier collecteur C41. Ce deuxième boîtier collecteur peut comporter une ouverture afin de laisser passer le flux d'air externe 500. Cette ouverture peut comporter un dispositif d'obturation (non représenté) mobile entre une première position dite ouverte et une deuxième position dite d'obturation. Ce dispositif d'obturation est notamment configuré pour permettre au flux d'air externe 500 de passer au travers ladite ouverture dans sa position ouverte et obturer ladite ouverture dans sa position d'obturation. Le dispositif d'obturation peut se présenter sous différentes formes comme par exemple sous la forme d'une pluralité de volets montés pivotants entre une position d'ouverture et une position de fermeture. Ces volets sont de préférence montés parallèles à la largeur du module de refroidissement C. Néanmoins, il est tout à fait possible d'imaginer d'autres configurations comme par exemple des volets montés parallèles à la hauteur du module de refroidissement. Les volets peuvent être des volets de type drapeau mais d'autres types de volets comme des volets papillons sont tout à fait envisageables.

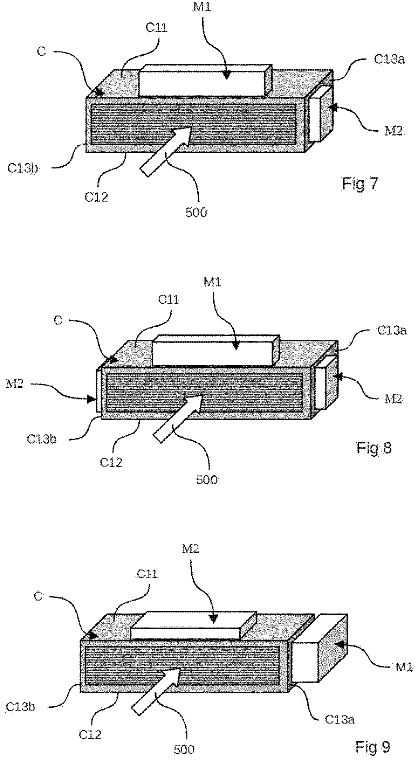

Le module de refroidissement C comporte un côté supérieur C11. un côté inférieur C12, un premier C13a et un deuxième C13b (visible sur les figures 7 à 12) côté latéral opposés l'un à l'autre. Par côté supérieur C11, on entend ici le côté du module de refroidissement C opposé à la sortie C45. Par côté inférieur C12, on entend ici le côté du module de refroidissement C opposé au côté supérieur C11 et faisant face à la sortie C45. Ces différents côtés C11, C12, C13a, C13b forment une paroi externe du module de refroidissement C.

Le dispositif de gestion thermique comporte également un dispositif de chauffage, ventilation et d'air conditionné D destiné à être traversé par un flux d'air interne 400 à destination d'un habitacle. Un tel dispositif de chauffage, ventilation et d'air conditionné D est illustré à la figure 3. Le dispositif de chauffage, ventilation et d'air conditionné D comprend notamment, au sein d'un boitier, un refroidisseur 66, 46, destiné à refroidir le flux d'air interne 400, un deuxième échangeur de chaleur 65, destiné à réchauffer le flux d'air interne 400, et un moyen de ventilation D1 configurer pour générer le flux d'air interne 400.

Le dispositif de chauffage, ventilation et d'air conditionné D peut notamment être disposé à l'extérieur de la plateforme modulaire A par exemple au sein d'un habitacle installé sur ladite plateforme modulaire A. Dans ce cas de figure, le dispositif de gestion thermique comporte une interface de connexion I destinée à permettre la connexion fluidique du dispositif de chauffage, ventilation et d'air conditionné D à des circuits de fluides caloporteur X, Y et aux éléments du dispositif de gestion thermique disposés au sein de la plateforme modulaire A.

Le dispositif de gestion thermique comporte enfin une interface d'échange thermique BAT avec les batteries B. L'interface d'échange thermique BAT est notamment disposée au sein de la plateforme modulaire A.

Les différents modules M1, M2, le module de refroidissement C, le dispositif de chauffage, ventilation et d'air conditionné D et l'interface d'échange thermique BAT avec les batteries B sont connectés les uns autres de sorte à former des circuits de fluides caloporteur X, Y Z.

L'utilisation d'un premier module M1, d'un deuxième module M2 ainsi que d'un module de refroidissement C et d'un dispositif de chauffage, ventilation et d'air conditionné D permet d'avoir un dispositif de gestion thermique compact et pouvant s'intégrer facilement au sein de la plateforme modulaire A. De plus, l'intégration de plusieurs composants du premier circuit de fluide caloporteur X au sein du premier module M1, et l'intégration d'autres composants du deuxième circuit de fluide caloporteur Y au sein du deuxième module M2, permet de faciliter l'installation du dispositif de gestion thermique au sein de la plateforme modulaire. En effet, ces modules M1, M2 ainsi que le module de refroidissement C peuvent être installés et directement connectés les uns aux autres pour former au moins en partie le dispositif de gestion thermique.

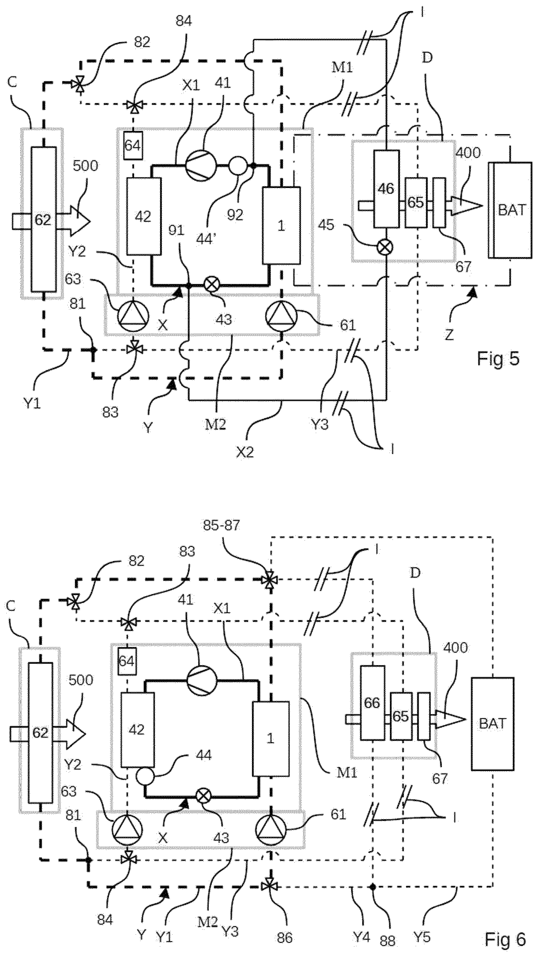

Les figures 4 et 5 montrent différents exemples de dispositifs de gestion thermique comportant trois circuits circulation connectés chacun à un échangeur de chaleur multi-fluide 1, ici tri-fluide. Le dispositif de gestion thermique comporte ainsi un premier circuit de fluide caloporteur X au sein duquel est destiné à circuler un premier fluide caloporteur, un deuxième circuit de fluide caloporteur X au sein duquel est destiné à circuler un deuxième fluide caloporteur et un troisième circuit de fluide caloporteur Z au sein duquel est destiné à circuler un troisième fluide caloporteur.

Le premier module M1 comporte plus précisément le premier circuit de fluide caloporteur X et les composants qui le composent.

Au sein du premier circuit de fluide caloporteur X est destiné à circuler un premier fluide caloporteur, notamment un fluide réfrigérant, par exemple du CO2, du R134a ou encore du R1234y. Le premier circuit de fluide caloporteur X comporte plus particulièrement une boucle principale X1 comprenant, dans le sens de circulation du fluide réfrigérant, un compresseur 41, un premier échangeur de chaleur 42, un premier dispositif de détente 43 et l'échangeur de chaleur tri-fluide 1.

Le premier échangeur de chaleur 42 du premier circuit de fluide caloporteur X est plus particulièrement un condenseur configuré pour permettre les échanges de chaleur entre le premier fluide caloporteur du premier circuit de fluide caloporteur X et le deuxième fluide caloporteur du deuxième circuit de fluide caloporteur Y.

Au sein du deuxième circuit de fluide caloporteur Y est destiné à circuler un deuxième fluide caloporteur, par exemple de l'eau ou de l'eau glycolée. Le deuxième circuit de fluide caloporteur Y comprend notamment une boucle principale Y1 comportant une première pompe 61, un premier échangeur de chaleur 62. L'échangeur de chaleur tri-fluide 1 étant également connecté à ladite boucle principale Y1 du deuxième circuit de fluide caloporteur Y. Cette première pompe 61 est notamment intégrée dans le deuxième module M2.

Le premier échangeur de chaleur 62 du deuxième circuit de fluide caloporteur Y peut être quant à lui un radiateur destiné à être traversé par un flux d'air externe 500. Le premier échangeur de chaleur 62 est alors intégré au sein du module de refroidissement C.

Le deuxième circuit de fluide caloporteur Y comporte une première branche de dérivation Y2 connectée à la boucle principale Y1 en parallèle du premier échangeur de chaleur 62 dudit deuxième circuit de fluide caloporteur Y. Plus particulièrement, la première branche de dérivation Y2 relie un premier point de raccordement 81 à un deuxième point de raccordement 82. Le premier point de raccordement 81 est disposé sur la boucle principale Y1 en aval du premier échangeur de chaleur 62, entre ledit premier échangeur de chaleur 62 et la première pompe 61. Le deuxième point de raccordement 82 est quant à lui disposé sur la boucle principale Y1 en amont du premier échangeur de chaleur 62, entre l'échangeur de chaleur tri-fluide 1 et ledit premier échangeur de chaleur 62. Ladite première branche de dérivation Y2 peut notamment comporter une deuxième pompe 63 ainsi que le premier échangeur de chaleur 42 du premier circuit de fluide caloporteur X. Cette deuxième pompe 63 est plus particulièrement intégrée dans le deuxième module M2.

La première branche de dérivation Y2 peut également comporter un réchauffeur électrique 64 du deuxième fluide caloporteur disposé en aval du premier échangeur de chaleur 42 du premier circuit de fluide caloporteur X. Ce réchauffeur électrique 64 peut être quant à lui intégré au sein du premier module M1.

Toujours selon les architectures illustrées aux figures 4 et 5, le deuxième circuit de fluide caloporteur Y comporte une deuxième branche de dérivation Y3 connectée à la première branche de dérivation Y2 en parallèle du premier échangeur de chaleur 42 du premier circuit de fluide caloporteur X et de la deuxième pompe 63. Plus particulièrement, cette deuxième branche de dérivation Y3 relie un troisième point de raccordement 83 à un quatrième point de raccordement 84. Le troisième point de raccordement 83 est disposé sur la première branche de dérivation Y2 en aval du premier échangeur de chaleur 42 du premier circuit de fluide caloporteur X et de la deuxième pompe 63, en amont du deuxième point de raccordement 82. Le quatrième point de raccordement 84 est quant à lui disposé sur la première branche de dérivation Y2 en amont du premier échangeur de chaleur 42 du premier circuit de fluide caloporteur X et de la deuxième pompe 63, en aval du premier point de raccordement 81. La deuxième branche de dérivation Y3 comporte un deuxième échangeur de chaleur 65 du deuxième circuit de fluide caloporteur Y. Ce deuxième échangeur de chaleur 65 est plus particulièrement intégré au sein du dispositif de chauffage, ventilation et d'air conditionné D.

Afin de contrôler le flux du deuxième fluide caloporteur, le deuxième circuit de fluide caloporteur Y comporte des moyens de redirections tels que des vannes trois-voies disposées par exemple :
- sur le deuxième point de raccordement 82 de sorte à rediriger le deuxième fluide caloporteur issue de l'échangeur de chaleur tri-fluide 1 vers le premier échangeur de chaleur 62 ou le deuxième échangeur de chaleur 62 ou de sorte à rediriger le deuxième fluide caloporteur issue du troisième point de raccordement 83 vers le premier échangeur de chaleur 62,
- sur le troisième point de raccordement 83 de sorte à rediriger le deuxième fluide caloporteur issue du deuxième point de raccordement 82 vers le deuxième échangeur de chaleur 65 ou de sorte à rediriger le deuxième fluide caloporteur issue du premier échangeur de chaleur 42 du premier circuit de fluide caloporteur X vers le de deuxième point de raccordement 82 ou vers le deuxième échangeur de chaleur 65,
- sur le troisième point de raccordement 83 de sorte à rediriger le deuxième fluide caloporteur issue du premier échangeur de chaleur 62 ou le deuxième fluide caloporteur issue du deuxième échangeur de chaleur 65 vers le premier échangeur de chaleur 42 du premier circuit de fluide caloporteur X.

D'autres moyens de redirection tels que des vannes d'arrêt peuvent également être envisagés.

Ces moyens de redirection du deuxième fluide caloporteur font partie du deuxième module M2.

Dans les architectures des figures 4 et 5, l'interface d'échange thermique BAT avec les batteries B est disposé au sein du troisième circuit de fluide caloporteur Z dans lequel est destiné à circuler un troisième fluide caloporteur, notamment un fluide diélectrique. Ce troisième circuit de fluide caloporteur Z est connecté à l'échangeur de chaleur tri-fluide 1 et l'interface d'échange thermique BAT est un contenant dans lequel les batteries baignent au moins partiellement et/ou sont soumises à une vaporisation du fluide diélectrique.

Le troisième circuit de fluide caloporteur Z peut également comporter une pompe (non représentée) afin de faire circuler le fluide diélectrique au sein de l'interface d'échange thermique BAT et du circuit en lui-même. Cette pompe peut notamment être intégrée directement à l'interface d'échange thermique BAT pour un gain de place.

L'échangeur de chaleur tri-fluide 1 est plus particulièrement configuré pour permettre les échanges de chaleur entre les deuxième et troisième fluides caloporteur et le premier fluide caloporteur. L'utilisation d'un tel échangeur de chaleur tri-fluide 1 permet, au sein d'un même échangeur de chaleur, les échanges de chaleur à la foi entre le premier fluide caloporteur et le deuxième fluide caloporteur et entre le premier fluide caloporteur et le troisième fluide caloporteur. Ainsi, il est possible avec un seul échangeur de chaleur de coupler thermiquement trois circuits de circulation distincts avec trois fluides caloporteurs de nature différente. Le fait de regrouper ces échanges thermiques au sein d'un même échangeur de chaleur tri-fluide 1 permet également un gain de place au sein du véhicule automobile par rapport à un dispositif de gestion thermique à trois circuits de circulation avec premier échangeur de chaleur dédié aux échanges de chaleur entre le premier fluide caloporteur et le deuxième fluide caloporteur et un deuxième échangeur de chaleur dédié aux échanges de chaleur entre le premier fluide caloporteur et le troisième fluide caloporteur.

Selon l'architecture illustrée à la figure 4, le deuxième circuit de fluide caloporteur Y peut comporter en outre une troisième branche de dérivation Y4 connectée à la boucle principale Y1 en parallèle de la première pompe 61 et de l'échangeur de chaleur tri-fluide 1. Plus particulièrement, cette troisième branche de dérivation Y4 relie un cinquième point de raccordement 85 à un sixième point de raccordement 86. Le cinquième point de raccordement 85 est disposé sur la boucle principale Y1 en aval de l'échangeur de chaleur tri-fluide 1 et de la première pompe 61 et en amont du deuxième point de raccordement 82. Le sixième point de raccordement 86 est quant à lui disposé sur la boucle principale Y1 en amont de l'échangeur de chaleur tri-fluide 1 et de la première pompe 61 et en aval du premier point de raccordement 81. La troisième branche de dérivation Y4 comporte un refroidisseur 66 destiné à être traversé par le flux d'air interne 400 à destination de l'habitacle. Ce refroidisseur 66 est notamment intégré au sein d'un dispositif de chauffage, ventilation et d'air conditionné D, de préférence en amont du deuxième échangeur de chaleur 65 dans le sens de circulation du flux d'air interne.

Afin de contrôler le deuxième fluide caloporteur, le deuxième circuit de fluide caloporteur Y comporte des moyens de redirection comme par exemple des vannes trois-voies disposées respectivement :
- sur le sixième point de raccordement 86 pour rediriger le deuxième fluide caloporteur en provenance du premier échangeur de chaleur 62 ou en provenance du refroidisseur 66 vers l'échangeur de chaleur tri-fluide 1,
- sur le cinquième point de raccordement 85 pour rediriger le deuxième fluide caloporteur en provenance de l'échangeur de chaleur tri-fluide 1 vers le refroidisseur 66 ou vers le deuxième point de raccordement 82.

D'autres moyens de redirection tels que des vannes d'arrêt peuvent également être envisagés.

De même, ces moyens de redirection du deuxième fluide caloporteur font faire partie du deuxième module M2.

Selon cette première variante, le premier circuit de fluide caloporteur X peut également comporter une bouteille dessiccante 44 disposée en aval du premier échangeur de chaleur 42. Cette bouteille dessiccante 44 peut notamment être accolée à la sortie de premier fluide caloporteur du premier échangeur de chaleur 42. Cette bouteille dessiccante 44 est ainsi intégrée dans le premier module M1.

Selon une autre architecture illustrée à la figure 5, le deuxième circuit de fluide caloporteur Y ne comporte pas une troisième branche de dérivation Y4 avec un refroidisseur 66. Dans cette architecture de la figure 5, le premier circuit de fluide caloporteur X comporte une première branche de dérivation X2 connectée sur la boucle principale X1 en parallèle du premier dispositif de détente 43 et de l'échangeur de chaleur tri-fluide 1. Cette première branche de dérivation X1 du premier circuit de fluide caloporteur X, relie plus particulièrement un premier point de raccordement 91 à un deuxième point de raccordement 92. Le premier point de raccordement 91 est disposé sur la boucle principale X1 en amont du premier dispositif de détente 43, entre le premier échangeur de chaleur 42 du premier circuit de fluide caloporteur X et ledit premier dispositif de détente 43. Le deuxième point de raccordement 92 est quant à lui disposé sur la boucle principale X1 en aval de l'échangeur de chaleur tri-fluide 1, entre ledit échangeur de chaleur tri-fluide 1 et le compresseur 41. Cette première branche de dérivation X2 comporte un deuxième dispositif de détente 45 et un évaporateur 46 destiné à être traversé par un flux d'air interne 400 à destination de l'habitacle. Cet évaporateur 46 ainsi que le deuxième dispositif de détente 45 sont intégré au sein d'un dispositif de chauffage, ventilation et d'air conditionné D. De préférence, l'évaporateur 46 est disposé en amont du deuxième échangeur de chaleur 65 dans le sens de circulation du flux d'air interne 400.

Afin de contrôler le premier fluide caloporteur et permettre ou non qu'il passe par la première branche de dérivation X2, les premier 43 et deuxième 45 dispositifs de détentes peuvent être des vannes d'expansion électroniques disposant d'une fonction d'arrêt. D'autres moyens de redirection tels que des vannes d'arrêt ou des vannes trois-voies peuvent également être envisagés.

Selon cette deuxième variante, le premier circuit de fluide caloporteur X peut également comporter un accumulateur 44' disposée en amont du compresseur 41. Cet accumulateur 44' peut notamment être disposé plus spécifiquement en aval du deuxième point de raccordement 92. Cet accumulateur 44' est ainsi intégré dans le premier module M1.

Le dispositif de gestion thermique peut comporter également un radiateur électrique 67 disposé dans le flux d'air interne 400 à destination de l'habitacle pour aider à son chauffage. Ce radiateur électrique 67 peut être intégré au sein du dispositif de chauffage, ventilation et d'air conditionné D, de préférence le plus en aval dans le sens de circulation du flux d'air interne par rapport aux autres échangeurs de chaleur dudit dispositif de chauffage, ventilation et d'air conditionné D.

La figure 6 montre un autre mode de réalisation dans lequel l'interface d'échange thermique BAT est par exemple une plaque froide connectée au deuxième circuit de fluide caloporteur X. Plus précisément, l'interface d'échange thermique BAT est disposée au sein d'une quatrième branche de dérivation Y5 du deuxième circuit de fluide caloporteur Y connecté en parallèle du premier échangeur de chaleur 62 du deuxième circuit de fluide caloporteur Y. L'échangeur de chaleur multi-fluide 1 n'est donc ici plus tri-fluide mais simplement bi-fluide.

Dans l'exemple de la figure 6, qui est une variante de la figure 4, la quatrième branche de dérivation Y5 relie un septième point de raccordement 87 à un huitième point de raccordement 88. Le septième point de raccordement 87 est disposé en aval de l'échangeur de chaleur multi-fluide 1, ici confondu avec le cinquième point de raccordement 85. Le huitième point de raccordement 88 est quant à lui disposé en aval du premier échangeur de chaleur 62, ici sur la troisième branche de dérivation Y4, en aval du refroidisseur 66. Le flux de deuxième fluide caloporteur est redirigé ou non vers la quatrième branche de dérivation Y5 par un moyen de redirection, ici une vanne quatre-voies disposée sur les cinquième 85 et septième 87 points de raccordement. D'autres moyens de redirection peuvent tout à fait être utilisés comme par exemple un ensemble de vannes d'arrêt. De même, ce moyen de redirection du deuxième fluide caloporteur peut avantageusement faire partie du deuxième module M2.

Afin de limiter l'encombrement du dispositif de gestion thermique, au moins une partie des composants premier module M1 et du deuxième module M2 sont disposés sur la paroi externe du module de refroidissement C, comme illustré sur les figures 7 à 12.

Selon un premier mode de réalisation illustré aux figures 7 et 8, les composants du premier module M1 sont regroupés sur le côté supérieur C11 du module de refroidissement C. Le fait de mettre ces composants, c'est à dire le compresseur 41, le premier dispositif de détente 43, l'échangeur de chaleur multi-fluide 1 et le premier échangeur de chaleur 42, sur ce côté supérieur, permet premièrement d'avoir un encombrement minimum mais également permet de protéger ces composants d'éventuels projectiles ou impacts pouvant venir du sous-bassement du véhicule automobile.

Selon une première variante de ce premier mode de réalisation illustré à la figure 7, les composants du deuxième module M2 peuvent être disposés sur un même côté latéral C13a, C13b du module de refroidissement C. La premier pompe 61, la deuxième pompe 63 ainsi que les différentes vannes des moyens de redirection du deuxième fluide caloporteur sont ainsi toutes regroupées sur un même côté latéral C13a, C13b.

Selon une première variante de ce premier mode de réalisation illustré à la figure 8, les composants du deuxième module M2 sont répartis entre les deux côtés latéraux C13a, C13b du module de refroidissement C. Par exemple, la première 61 et la deuxième 62 pompes peuvent être disposées sur le premier côté latéral C13a avec notamment les moyens de redirection des quatrième 84 et sixième 86 points de raccordement. Les moyens de redirection des deuxième 82, troisième 83, cinquième 85 et éventuellement septième 87 points de raccordement peuvent quant à eux être disposés sur le deuxième côté latéral C13b.

Les figures 9 à 12 montrent un deuxième mode de réalisation dans lequel le compresseur 41 et le premier échangeur de chaleur 42 du premier module M1 sont regroupés sur un même côté latéral C13a, C13b du module de refroidissement C.

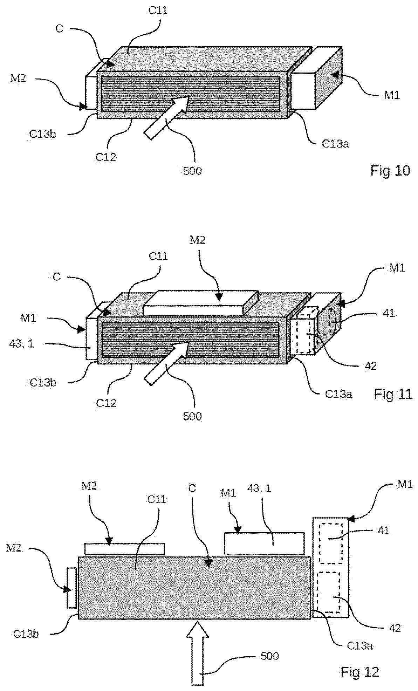

Selon une première variante de ce deuxième mode de réalisation illustrée aux figures 9 et 10, le premier dispositif de détente 43 et l'échangeur de chaleur multi-fluide 1 sont disposé sur le même coté latéral C13a, C13b que le compresseur 41 et le premier échangeur de chaleur 42. Dans l'exemple illustré à la figure 9, les composants du deuxième module M2 sont disposés sur le côté supérieur C11 du module de refroidissement C. Dans l'exemple illustré à la figure 10, les composants du deuxième module M2 sont disposés sur un côté latéral C13a, C13b du module de refroidissement C opposé au côté latéral C13a, C13b comportant le compresseur 41 et le premier échangeur de chaleur 42.

Selon une deuxième variante du deuxième mode de réalisation illustrée à la figure 11, le premier dispositif de détente 43 et l'échangeur de chaleur multi-fluide 1 sont disposé sur un côté latéral C13a, C13b opposé au côté latéral C13a, C13b comportant le compresseur 41 et le premier échangeur de chaleur 42. Le premier module M1 est ainsi reparti sur les deux côtés latéraux C13a, C13b du module de refroidissement C. Selon cette deuxième variante, les composants du deuxième module M2 sont disposés sur le côté supérieur C11 du module de refroidissement C.

La figure 12 montre une troisième variante du deuxième mode de réalisation dans lequel le premier dispositif de détente 43 et l'échangeur de chaleur multi-fluide 1 sont disposé dans le prolongement dudit module de refroidissement C, en regard d'un côté dudit module de refroidissement C opposé au premier échangeur de chaleur 62. Cela permet notamment de limiter l'augmentation de la largeur du dispositif de gestion thermique en limitant le nombre de composants disposés sur les côtés latéraux C13a, C13b du module de refroidissement C. Selon cette troisième variante, les composants du deuxième module M2 peuvent également être répartis entre :
- un côté latéral C13a, C13b du module de refroidissement C opposé au côté latéral C13a, C13b comportant le compresseur 41 et le premier échangeur de chaleur 42, et/ou
- l'arrière du module de refroidissement C dans le prolongement dudit module de refroidissement C.

Par exemple, la première 61 et la deuxième 62 pompes ainsi que les moyens de redirection des quatrième 84 et sixième 86 points de raccordement peuvent être disposées un côté latéral C13a, C13b du module de refroidissement C opposé au côté latéral C13a, C13b comportant le compresseur 41 et le premier échangeur de chaleur 42. Les moyens de redirection des deuxième 82, troisième 83, cinquième 85 et éventuellement septième 87 points de raccordement peuvent quant à eux être disposés ans le prolongement dudit module de refroidissement C, en regard d'un côté dudit module de refroidissement C opposé au premier échangeur de chaleur 62.

De préférence, dans cette troisième variante, les composants du premier M1 et du deuxième M2 module sont disposés en regard du côté du module de refroidissement C opposé au premier échangeur de chaleur 62 de sorte à ne pas gêner l'évacuation du flux d'air externe 500. Pour cela, ces composants sont de préférence décalés par rapport à la sortie C31 du module de refroidissement C.

Ainsi, on voit bien que le placement des composants du premier module M1 et du deuxième module M2 en périphérie du module de refroidissement C, permet de limiter l'encombrement du dispositif de gestion thermique et facilite sont intégration au sein d'une plateforme modulaire A.

## Revendications

1. Dispositif de gestion thermique pour plateforme modulaire (A) d'un châssis de véhicule automobile électrique, ladite plateforme modulaire (A) comportant les batteries (B) ainsi que le train de puissance électrique du véhicule automobile électrique, le dispositif de gestion thermique comportant :
- un premier module (M1) comprenant un premier circuit de fluide caloporteur (X) au sein duquel est destiné un premier fluide caloporteur, ledit premier circuit de fluide caloporteur (X) comportant un compresseur (41), un premier dispositif de détente (43) et un échangeur de chaleur multi-fluide (1) et un premier échangeur de chaleur (42),
- un module de refroidissement (C) étant destiné à être traversé par un flux d'air externe (500), ledit module de refroidissement (C) comportant au moins un premier échangeur de chaleur (62) destiné à être traversé par le flux d'air externe (500), le module de refroidissement (C) comportant un côté supérieur (C11), un côté inférieur (C12), un premier (C13a) et un deuxième (C13b) côtés latéraux opposés l'un à l'autre, lesdits côtés (C11, C12, C13a, C13b) formant une paroi externe du module de refroidissement (C), ledit module de refroidissement (C) étant destiné à être intégré au sein de la plateforme modulaire (A),
- un deuxième module (M2) comportant une première pompe (61) et une deuxième pompe (63) d'un deuxième circuit de fluide caloporteur (Y) au sein duquel est destiné un deuxième fluide caloporteur, ledit deuxième module (M2) comportant en outre des moyens de redirection du deuxième fluide caloporteur au sein dudit deuxième circuit de fluide caloporteur (Y),
au moins une partie des composants du premier module (M1) sont disposés sur la paroi externe du module de refroidissement (C), et
**caractérisé en ce qu'**au moins une partie des composants et du deuxième module (M2 ) sont disposés sur la paroi externe du module de refroidissement (C).

2. Dispositif de gestion thermique selon la revendication 1, **caractérisé en ce que** les composants du premier module (M1) sont regroupés sur le côté supérieur (C11) du module de refroidissement (C).

3. Dispositif de gestion thermique selon la revendication 2, **caractérisé en ce que** les composants du deuxième module (M2) sont disposés sur un même côté latéral (C13a, C13b) du module de refroidissement (C).

4. Dispositif de gestion thermique selon la revendication 2, **caractérisé en ce que** les composants du deuxième module (M2) sont répartis entre les deux côtés latéraux (C13a, C13b) du module de refroidissement (C).

5. Dispositif de gestion thermique selon la revendication 1, **caractérisé en ce que** le compresseur (41) et le premier échangeur de chaleur (42) du premier module (M1) sont regroupés sur un même côté latéral (C13a, C13b) du module de refroidissement (C).

6. Dispositif de gestion thermique selon la revendication 5, **caractérisé en ce que** le premier dispositif de détente (43) et l'échangeur de chaleur multi-fluide (1) du premier module (M1) sont disposé sur le même coté latéral (C13a, C13b) que le compresseur (41) et le premier échangeur de chaleur (42) du premier module (M1).

7. Dispositif de gestion thermique selon la revendication 5, **caractérisé en ce que** le premier dispositif de détente (43) et l'échangeur de chaleur multi-fluide (1) sont disposé sur un côté latéral (C13a, C13b) opposé au côté latéral (C13a, C13b) comportant le compresseur (41) et le premier échangeur de chaleur (42) du premier module (M1).

8. Dispositif de gestion thermique selon l'une quelconque des revendications 6 ou 7, **caractérisé en ce que** les composants du deuxième module (M2) sont disposés sur le côté supérieur (C11) du module de refroidissement (C).

9. Dispositif de gestion thermique selon la revendication 6, **caractérisé en ce que** les composants du deuxième module (M2) sont disposés sur un côté latéral (C13a, C13b) du module de refroidissement (C) opposé au côté latéral (C13a, C13b) comportant les composants du premier module (M1).

10. Dispositif de gestion thermique selon la revendication 5, **caractérisé en ce que** le premier dispositif de détente (43) et l'échangeur de chaleur multi-fluide (1) sont disposés dans le prolongement dudit module de refroidissement (C), en regard d'un côté dudit module de refroidissement (C) opposé au premier échangeur de chaleur (62) dudit module de refroidissement (C).

11. Dispositif de gestion thermique selon la revendication 10, **caractérisé en ce que** les composants du deuxième module (M2) sont répartis entre :
- le côté latéral (C13a, C13b) du module de refroidissement (C) opposé au côté latéral (C13a, C13b) comportant le compresseur (41) et le premier échangeur de chaleur (42) du premier module (M1), et/ou
- dans le prolongement dudit module de refroidissement (C), en regard d'un côté dudit module de refroidissement (C) opposé au premier échangeur de chaleur (62) dudit module de refroidissement (C).

12. Plateforme modulaire (A) d'un châssis de véhicule automobile électrique, ladite plateforme modulaire (A) comportant les batteries (B) ainsi que le train de puissance électrique du véhicule automobile électrique, **caractérisée en ce que** ladite plateforme modulaire (A) comporte un dispositif de gestion thermique selon l'une quelconque des revendications 1 à 11.

## Patentansprüche

1. Eine Wärmemanagementvorrichtung für eine modulare Plattform (A) eines Elektrofahrzeug-Chassis, wobei die modulare Plattform (A) die Batterien (B) und den elektrischen Antriebsstrang des Elektrofahrzeugs umfasst, wobei die Wärmemanagementvorrichtung umfasst:
- ein erstes Modul (M1) mit einem ersten Wärmeträgerfluidkreislauf (X), in dem ein erstes Wärmeträgerfluid vorgesehen ist, wobein der erste Wärmeträgerfluidkreislauf (X) einen Kompressor (41), eine erste Expansionsvorrichtung (43), einen Mehrflüssigkeits-Wärmetauscher (1) und einen ersten Wärmetauscher (42) umfasst;
- ein Kühlmodul (C), das von einem externen Luftstrom (500) durchströmt wird, wobei das Kühlmodul (C) mindestens einen ersten Wärmetauscher (62) umfasst, der von dem externen Luftstrom (500) durchströmt wird, wobei das Kühlmodul (C) eine Oberseite (C11), eine Unterseite (C12), eine erste (C13a) und eine zweite (C13b) gegenüberliegende Seitenfläche, umfasst, wobei die Seitenflächen (C11, C12, C13a, C13b) die Außenwand des Kühlmoduls (C) bilden, wobei das Kühkmodul für die Integration in die modulare Plattform (A) vorgesehen ist,
- ein zweites Modul (M2), das eine erste Pumpe (61) und eine zweite Pumpe (63) eines zweiten Wärmeträgerkreislaufs (Y), in dem ein zweites Wärmeträgerfluid vorgesehen ist, umfasst, wobei das zweite Modul (M2) zudem Mittel zur Umleitung des zweiten Wärmeträgerfluids innerhalb des zweiten Wärmeträgerkreislaufs (Y) umfasst,
wobei zumindest einige der Komponenten des ersten Moduls (M1) an der Außenwand des Kühlmoduls (C) angeordnet sind,
**dadurch gekennzeichnet, dass** mindestens einige der Komponenten des zweiten Moduls (M2) an der Außenwand des Kühlmoduls (C) angeordnet sind.

2. Die Wärmemanagementvorrichtung nach Anspruch 1, **dadurch gekennzeichnet, dass** die Komponenten des ersten Moduls (M1) auf der Oberseite (C11) des Kühlmoduls (C) zusammengefasst sind.

3. Die Wärmemanagementvorrichtung nach Anspruch 2, **dadurch gekennzeichnet, dass** die Komponenten des zweiten Moduls (M2) auf derselben Seite (C13a, C13b) des Kühlmoduls (C) angeordnet sind.

4. Die Wärmemanagementvorrichtung nach Anspruch 2, **dadurch gekennzeichnet, dass** die Komponenten des zweiten Moduls (M2) auf die beiden Seiten (C13a, C13b) des Kühlmoduls (C) verteilt sind.

5. Die Wärmemanagementvorrichtung nach Anspruch 1, **dadurch gekennzeichnet, dass** der Kompressor (41) und der erste Wärmetauscher (42) des ersten Moduls (M1) auf derselben Seite (C13a, C13b) des Kühlmoduls (C) zusammengefasst sind.

6. Die Wärmemanagementvorrichtung nach Anspruch 5, **dadurch gekennzeichnet, dass** das erste Expansionsorgan (43) und der Mehrfluid-Wärmetauscher (1) des ersten Moduls (M1) auf derselben lateralen Seite (C13a, C13b) angeordnet sind wie der Kompressor (41) und der erste Wärmetauscher (42) des ersten Moduls (M1).

7. Die Wärmemanagementvorrichtung nach Anspruch 5, **dadurch gekennzeichnet, dass** das erste Expansionsorgan (43) und der Mehrfluid-Wärmetauscher (1) auf einer lateralen Seite (C13a, C13b) angeordnet sind, die der lateralen Seite (C13a, C13b) mit dem Kompressor (41) und dem ersten Wärmetauscher (42) des ersten Moduls (M1) gegenüberliegt.

8. Die Wärmemanagementvorrichtung nach Anspruch 6 oder 7, **dadurch gekennzeichnet, dass** die Komponenten des zweiten Moduls (M2) auf der Oberseite (C11) des Kühlmoduls (C) angeordnet sind.

9. Die Wärmemanagementvorrichtung nach Anspruch 6, **dadurch gekennzeichnet, dass** die Komponenten des zweiten Moduls (M2) auf einer der Seitenfläche (C13a, C13b) des Kühlmoduls (C) gegenüberliegenden Seite (C13a, C13b) mit den Komponenten des ersten Moduls (M1) angeordnet sind.

10. Die Wärmemanagementvorrichtung nach Anspruch 5, **dadurch gekennzeichnet, dass** die erste Expansionsvorrichtung (43) und der Mehrfluid-Wärmetauscher (1) in der Verlängerung des Kühlmoduls (C) angeordnet sind, gegenüber einer dem ersten Wärmetauscher (62) des Kühlmoduls (C) gegenüberliegenden Seite des Kühlmoduls (C).

11. Die Wärmemanagementvorrichtung nach Anspruch 10, **dadurch gekennzeichnet, dass** die Komponenten des zweiten Moduls (M2) auf:
- die der den Kompressor (41) und den ersten Wärmetauscher (42) des ersten Moduls (M1) umfassenden Seitenwand (C13a, C13b) des Kühlmoduls (C) gegenüberliegende Seitenwand (C13a, C13b) und/oder
- in der Verlängerung des Kühlmoduls (C), gegenüber einer dem ersten Wärmetauscher (62) des Kühlmoduls (C) gegenüberliegenden Seite verteilt sind.

12. Eine modulare Plattform (A) eines Elektrofahrzeug-Chassis, wobei die modulare Plattform (A) die Batterien (B) und den elektrischen Antriebsstrang des Elektrofahrzeugs umfasst, **dadurch gekennzeichnet, dass** die modulare Plattform (A) eine Wärmemanagementvorrichtung nach einem der Ansprüche 1 bis 11 umfasst.

## Claims

1. A thermal management device for a modular platform (A) of an electric motor vehicle chassis, said modular platform (A) comprising the batteries (B) and the electric powertrain of the electric motor vehicle, the thermal management device comprising:
- a first module (M1) comprising a first heat transfer fluid circuit (X) in which a first heat transfer fluid is intended, said first heat transfer fluid circuit (X) comprising a compressor (41), a first expansion device (43) and a multi-fluid heat exchanger (1) and a first heat exchanger (42),
- a cooling module (C) being intended to have an external air flow (500) passing through it, said cooling module (C) comprising at least a first heat exchanger (62) intended to have the external air flow (500) passing through it, the cooling module (C) comprising an upper side (C11), a lower side (C12), a first (C13a) and a second (C13b) lateral sides opposite one another, said sides (C11, C12, C13a, C13b) forming an outer wall of the cooling module (C), said cooling module (C) being intended to be integrated within the modular platform (A),
- a second module (M2) comprising a first pump (61) and a second pump (63) of a second heat transfer fluid circuit (Y) in which a second heat transfer fluid is intended, said second module (M2) further comprising means for redirecting the second heat transfer fluid within said second heat transfer fluid circuit (Y),
at least some of the components of the first module (M1) being arranged on the outer wall of the cooling module (C).
**characterized in that** at least some of the components of the second module (M2) are arranged on the outer wall of the cooling module (C).

2. The thermal management device as claimed in claim 1, **characterized in that** the components of the first module (M1) are grouped together on the upper side (C11) of the cooling module (C).

3. The thermal management device as claimed in claim 2, **characterized in that** the components of the second module (M2) are arranged on the same lateral side (C13a, C13b) of the cooling module (C).

4. The thermal management device as claimed in claim 2, **characterized in that** the components of the second module (M2) are distributed between the two lateral sides (C13a, C13b) of the cooling module (C).

5. The thermal management device as claimed in claim 1, **characterized in that** the compressor (41) and the first heat exchanger (42) of the first module (M1) are grouped together on the same lateral side (C13a, C13b) of the cooling module (C).

6. The thermal management device as claimed in claim 5, **characterized in that** the first expansion device (43) and the multi-fluid heat exchanger (1) of the first module (M1) are arranged on the same lateral side (C13a, C13b) as the compressor (41) and the first heat exchanger (42) of the first module (M1).

7. The thermal management device as claimed in claim 5, **characterized in that** the first expansion device (43) and the multi-fluid heat exchanger (1) are arranged on a lateral side (C13a, C13b) opposite the lateral side (C13a, C13b) comprising the compressor (41) and the first heat exchanger (42) of the first module (M1).

8. The thermal management device as claimed in either of claims 6 and 7, **characterized in that** the components of the second module (M2) are arranged on the upper side (C11) of the cooling module (C).

9. The thermal management device as claimed in claim 6, **characterized in that** the components of the second module (M2) are arranged on a lateral side (C13a, C13b) of the cooling module (C) opposite the lateral side (C13a, C13b) comprising the components of the first module (M1).

10. The thermal management device as claimed in claim 5, **characterized in that** the first expansion device (43) and the multi-fluid heat exchanger (1) are arranged in the extension of said cooling module (C), facing a side of said cooling module (C) opposite the first heat exchanger (62) of said cooling module (C).

11. The thermal management device as claimed in claim 10, **characterized in that** the components of the second module (M2) are distributed between:
- the lateral side (C13a, C13b) of the cooling module (C) opposite the lateral side (C13a, C13b) comprising the compressor (41) and the first heat exchanger (42) of the first module (M1), and/or
- in the extension of said cooling module (C), facing a side of said cooling module (C) opposite the first heat exchanger (62) of said cooling module (C).

12. A modular platform (A) of an electric motor vehicle chassis, said modular platform (A) comprising the batteries (B) and the electric powertrain of the electric motor vehicle, **characterized in that** said modular platform (A) comprises a thermal management device as claimed in any one of claims 1 to 11.
